# EUROPEAN PATENT APPLICATION

(11) **EP 4 567 485 A2**
(43) Date of publication of application: **11.06.2025**
(21) Application number: 24212579.7
(22) Date of filing: 13.11.2024
(51) Int. Cl.: G02B 6/42

(54) **LID FOR OPTICAL PACKAGES**

(30) Priority: 17.11.2023 US 202363600172 P; 10.04.2024 US 202418631558
(71) Applicant: Avago Technologies International Sales Pte. Limited, Singapore 768923 (SG)
(72) Inventor: Meadowcroft, David John Kenneth, Bury St Edmunds, Suffolk IP327FF (GB); Chan, Seng-Kum, San Jose, 95124 (US); Goh, Han Peng, 578041 Singapore (SG); Zhang, Sheng, Cupertino, 95014 (US); Chung, Jack YuChieh, San Jose, 95124 (US)
(74) Representative: Bosch Jehle Patentanwaltsgesellschaft mbH

(57) **Abstract**

Novel tools and techniques are provided for implementing a semiconductor package or a chip package, and more particularly methods, systems, and apparatuses are provided for implementing a semiconductor package or a chip package including an optical package or co-packaged optics package comprising a lid. In an embodiment, an optical package can include a first substrate, a first circuit coupled to the first substrate and configured to transmit or receive an electrical signal, a second circuit coupled to the first substrate and configured to transmit or receive an optical signal, and a lid configured to couple to the first substrate and configured to cover at least a portion of the first circuit or the second circuit.

## Description

This application claims priority to U.S. Patent Application Ser. No. 63/600,172 (the " '172 Application"), filed November 17, 2023, by David Meadowcroft, et al., entitled, "CPO Integrated Socket Lid IP Rev A," the disclosure of which is incorporated herein by reference in its entirety for all purposes.

A portion of the disclosure of this patent document contains material that is subject to copyright protection. The copyright owner has no objection to the facsimile reproduction by anyone of the patent document or the patent disclosure as it appears in the Patent and Trademark Office patent file or records, but otherwise reserves all copyright rights whatsoever.

The present disclosure relates, in general, to methods, systems, and apparatuses for implementing a semiconductor device comprising a lid for an optical package such as a co-packaged optics (CPO) package.

Co-Packaged Optics (CPO) involves the integration of optics and electronics in a package aimed at addressing next generation bandwidth and power challenges. As data rates increase there is a strong trend to move high-speed signals of an optical transceiver closer to the switch silicon. In a non-limiting example, a CPO package can include the mounting of optical transceivers proximate to the switch silicon.

In various cases, in order to mount the CPO package to a substrate, the CPO package may use a separate lid that is separate from the CPO package to couple the CPO package to the substrate. The purpose of the lid is to couple the CPO package to the substrate and to connect (e.g., electrically connect or the like) one or more connections of the CPO package to one or more connections of the substrate.

Hence, there is a need for more robust and scalable solutions for implementing a semiconductor package or a chip package comprising a lid for an optical package such as a CPO package. Thus, methods, systems, and apparatuses are provided for implementing semiconductor packages or chip packages comprising lids for CPO packages.

According to an aspect, an optical package comprises:
a first substrate;
a first circuit coupled to the first substrate and configured to transmit or receive an electrical signal;
a second circuit coupled to the first substrate and configured to transmit or receive an optical signal; and
a lid configured to couple to the first substrate and configured to cover at least one of a portion of the first circuit or a portion of the second circuit.

Advantageously, the lid directly contacts at least one of the portion of the first circuit or the portion of the second circuit.

Advantageously, the lid is configured to couple the optical package to a second substrate.

Advantageously, the second substrate comprises a printed circuit board, and wherein the lid couples the optical package to the printed circuit board.

Advantageously, the optical package further comprises a connector between the first substrate and the second substrate, wherein the lid comprises a fastener configured to couple the lid to the second substrate, wherein the fastener is configured to provide a force to form a first connection between the first substrate and the connector and a second connection between the connector and the second substrate.

Advantageously, the lid comprises an opening configured to receive a source configured to transmit or receive the optical signal, wherein the source is coupled to the second circuit.

Advantageously, the lid further comprises a cover configured to cover the opening.

Advantageously, at least a portion of a bottom surface of the cover comprises a material configured to form a seal surrounding the source as the source enters the opening.

Advantageously, the lid comprises an opening configured to receive a source configured to transmit or receive the optical signal, wherein the source is coupled to the second circuit, wherein the opening is formed by a sidewall of the lid, two walls extending from the sidewall, and a bar extending between the two walls extending from the sidewall, and wherein a first material is attached to a top surface of the bar.

Advantageously, the lid further comprises a cover configured to cover the opening, and wherein a second material is attached to at least a portion of a bottom surface of the cover, and wherein the second material is configured to contact the first material and form a seal surrounding the source as the source enters the opening.

Advantageously, the lid comprises an opening configured to receive a source configured to transmit or receive the optical signal, wherein the source is coupled to the second circuit, and wherein the lid further comprises a protrusion comprising a first end coupled to and extending from a sidewall of the lid into the opening and a second end coupled to the second circuit.

Advantageously, a width of the protrusion is about a same width as a width of the second circuit.

Advantageously, a bottom surface of the lid comprises a bar configured to distribute a force of the lid over the first substrate.

Advantageously, the bar is located between two second circuits.

Advantageously, a bottom surface of the lid comprises a slanted surface and wherein the slanted surface is positioned over at least one of the first circuit or the second circuit.

According to an aspect, an optical system comprises:
a first substrate;
a second substrate;
a connector between the first substrate and the second substrate configured to transmit a first signal between the first substrate and the second substrate;
a circuit coupled to the first substrate and configured to at least one of transmit or receive an optical signal; and
a lid configured to couple the first substrate to the second substrate and form a first connection between the first substrate and the connector and a second connection between the connector and the second substrate to transmit or receive the first signal between the first substrate and the second substrate, and wherein the lid is further configured to directly cover at least a portion of the circuit.

Advantageously, the lid directly contacts the circuit.

Advantageously, the second substrate comprises a printed circuit board.

According to an aspect, a lid for an optical package comprises:
a body comprising an opening configured to receive a source configured to transmit or receive an optical signal; and
a portion of a bottom surface of the body configured to directly cover at least a portion of a circuit coupled to the source and a first substrate;
wherein the lid is further configured to couple the first substrate to a second substrate and provide a force to form a first connection between the first substrate and a connector and a second connection between the connector and the second substrate to transmit or receive a first signal between the first substrate and the second substrate.

Advantageously, the lid is formed from at least one of copper, zinc, aluminum, or ceramic.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
FIG. 1 is a perspective view of an embodiment of a semiconductor device comprising a lid, in accordance with various embodiments;
FIG. 2 is an exploded perspective view of an embodiment of the semiconductor device of FIG. 1 comprising a lid, in accordance with various embodiments;
FIG. 3 is a perspective view of another embodiment of a semiconductor device comprising a lid, in accordance with various embodiments;
FIG. 4 is a top view of a connector of a semiconductor device, in accordance with various embodiments;
FIG. 5 is a perspective view of a lid of the semiconductor device of FIG. 1, in accordance with various embodiments;
FIG. 6 is a perspective view of the lid of FIG. 5 comprising one or more covers, in accordance with various embodiments;
FIG. 7 is a bottom view of the lid of FIG. 5, in accordance with various embodiments;
FIG. 8 is a perspective view of the lid of FIG. 5 comprising a compliant material, in accordance with various embodiments;
FIG. 9 is a bottom view of an embodiment of the lid of FIG. 5 comprising one or more slanted surfaces, in accordance with various embodiments;
FIG. 10 is a close-up view of the semiconductor device of FIG. 1 showing a protrusion of the lid of FIG. 5, in accordance with various embodiments;
FIG. 11 is a close-up cross-sectional view of the semiconductor device of FIG. 1 showing the lid of FIG. 5 in contact with one or more dies, in accordance with various embodiments;
FIG. 12 is a close-up cross-sectional view of the semiconductor device of FIG. 1 showing a slanted surface of the lid of FIG. 5, in accordance with various embodiments;
FIG. 13 is a close-up bottom view of the semiconductor device of FIG. 1 showing a slanted surface of the lid of FIG. 5, in accordance with various embodiments;
FIG. 14 is a perspective view of the semiconductor device of FIG. 2 comprising a lid and a heatsink, in accordance with various embodiments; and
FIG. 15 is a flow diagram of a method of attaching a lid to an optical package, in accordance with various embodiments.

### DETAILED DESCRIPTION OF EMBODIMENTS

Various embodiments provide tools and techniques for implementing semiconductor packages or chip packages including one or more lids or lid components for an optical package such as a CPO package are described herein.

In a first aspect, an optical package can include a first substrate; a first circuit coupled to the first substrate and configured to transmit or receive an electrical signal; a second circuit coupled to the first substrate and configured to transmit or receive an optical signal; and a lid configured to couple to the first substrate and configured to cover at least one of a portion of the first circuit or a portion of the second circuit.

In various cases, the lid can directly contact at least one of the portion of the first circuit or the portion of the second circuit and can be configured to couple the optical package to a second substrate. The second substrate can include a printed circuit board and the lid can couple the optical package to the printed circuit board. In some instances, the optical package can further include a connector between the first substrate and the second substrate, the lid can include a fastener configured to couple the lid to the second substrate, and the fastener can be configured to provide a force to form a first connection between the first substrate and the connector and a second connection between the connector and the second substrate.

In some embodiments, the lid can include an opening configured to receive a source configured to transmit or receive the optical signal and the source can be coupled to the second circuit. The lid can further include a cover configured to cover the opening. In some examples, at least a portion of a bottom surface of the cover can include a material configured to form a seal surrounding the source as the source enters the opening.

In various instances, the lid can include an opening configured to receive a source configured to transmit or receive the optical signal. The source can be coupled to the second circuit. The opening can be formed by a sidewall of the lid, two walls extending from the sidewall, and a bar extending between the two walls extending from the sidewall. A first material can be attached to a top surface of the bar. In various embodiments, the lid can further include a cover configured to cover the opening and a second material can be attached to at least a portion of a bottom surface of the cover. In some instances, the second material can be configured to contact the first material and form a seal surrounding the source as the source enters the opening.

In some cases, the lid includes an opening configured to receive a source configured to transmit or receive the optical signal. The source can be coupled to the second circuit and the lid can further include a protrusion comprising a first end coupled to and extending from a sidewall of the lid into the opening and a second end coupled to the second circuit. In some instances, a width of the protrusion is about a same width as a width of the second circuit.

In various embodiments, a bottom surface of the lid can include a bar configured to distribute a force of the lid over the first substrate. The bar can be located between two second circuits.

In some instances, a bottom surface of the lid comprises a slanted surface and wherein the slanted surface is positioned over at least one of the first circuit or the second circuit.

In another aspect, an optical system can include a first substrate, a second substrate, a connector between the first substrate and the second substrate configured to transmit a first signal between the first substrate and the second substrate, a circuit coupled to the first substrate and configured to at least one of transmit or receive an optical signal, and a lid configured to couple the first substrate to the second substrate and form a first connection between the first substrate and the connector and a second connection between the connector and the second substrate to transmit or receive the first signal between the first substrate and the second substrate. The lid can be further configured to directly cover at least a portion of the circuit. In some cases, the lid can be configured to directly contact the circuit. In various cases, the second substrate comprises a printed circuit board.

In yet another aspect, a lid for an optical package can include a body comprising an opening configured to receive a source configured to transmit or receive an optical signal and a portion of a bottom surface of the body configured to directly cover at least a portion of a circuit coupled to the source and a first substrate. In some instances, the lid can be configured to couple the first substrate to a second substrate and provide a force to form a first connection between the first substrate and a connector and a second connection between the connector and the second substrate to transmit or receive a first signal between the first substrate and the second substrate. In some cases, the lid can be formed from at least one of copper, zinc, aluminum, or ceramic.

In the following description, for the purposes of explanation, numerous details are set forth to provide a thorough understanding of the described embodiments. It will be apparent to one skilled in the art, however, that other embodiments may be practiced without some of these details. Several embodiments are described herein, and while various features are ascribed to different embodiments, it should be appreciated that the features described with respect to one embodiment may be incorporated with other embodiments as well. By the same token, however, no single feature or features of any described embodiment should be considered essential to every embodiment of the invention, as other embodiments of the invention may omit such features.

When an element is referred to herein as being "connected," "coupled," or "attached" to another element (such as coupled or connected through an electrical or communicative connection or coupled or attached to a mechanical connection or attachment) or "covering" or "contacting" another element, it is to be understood that the elements can be directly connected to the other element or can be directly covering or contacting the other element, or have intervening elements present between the elements. In contrast, when an element is referred to as being "directly connected," "directly coupled," or "directly attached" to another element or "directly covering" or "directly contacting" another element, it should be understood that no intervening elements are present in the "direct" connection between the elements or no intervening elements are present between the element covering or contacting the other element. However, the existence of a direct connection or a direct cover or direct contact does not exclude other connections or covers or contacts, in which intervening elements may be present.

When an element is referred to herein as being "disposed" or "located" in some manner relative to another element (e.g., disposed on, disposed between, disposed under, disposed adjacent to, or disposed in some other relative manner), it is to be understood that the elements can be directly disposed or located relative to the other element (e.g., disposed directly on another element), or have intervening elements present between the elements. In contrast, when an element is referred to as being "disposed directly" or "located directly" relative to another element, it should be understood that no intervening elements are present in the "direct" example. However, the existence of a direct disposition does not exclude other examples in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Additionally, when an element is referred to herein as being an "electronic circuit," "circuit," or "electronic die", it is commonly recognized as a building block of modem electronics. Circuits are composed of various electronic components such as resistors, capacitors, inductors, diodes, transistors, and integrated circuits. In some cases, integrated circuits can be formed from one or more circuits. These electronic components are carefully selected and interconnected to create a circuit that can perform a specific task or carry out a particular function. Circuits can be as simple as a basic switch that turns a light on and off, or they can be incredibly complex, such as those found in advanced computer systems, communication devices, or medical equipment. Circuits can be categorized into different types based on their purpose or function, including amplifiers, oscillators, filters, power supplies, and logic gates, among others. Additionally, circuits can include software or firmware in addition to hardware or instead of hardware to carry out a particular function.

Further, when an element is referred to herein as being a "photonic circuit" or "photonic die," it is commonly recognized as a circuit configured to receive or transmit one or more optical signals. Photonic circuits can be composed of various electronic components such as resistors, capacitors, inductors, diodes, transistors, and integrated circuits and optical components such as lenses, optical sources, fibers, or the like. These electronic and optical components are carefully selected and interconnected to create a photonic circuit that can perform a specific task or carry out a particular function. In various cases, photonic circuits can be configured to receive or transmit optical signals, convert electrical signals to optical signals or optical signals to electrical signals, or the like. Additionally, photonic circuits can include software or firmware in addition to hardware or instead of hardware to carry out a particular function.

Additionally, various units, circuits, modules, or other components may be described as "configured to" or "adapted to" perform a task or tasks. In such contexts, "configured to" or "adapted to" is a broad recitation of structure generally meaning "having circuitry that" performs the task or tasks during operation. As such, the unit/circuit/module/component can be configured to perform the task even when the unit/circuit/module/component is not currently on. In general, the circuitry that forms the structure corresponding to "configured to" or "adapted to" may include hardware circuits and/or memory storing program instructions executable to implement the operation. The memory can include volatile memory such as static or dynamic random-access memory and/or nonvolatile memory such as optical or magnetic disk storage, flash memory, programmable read-only memories, etc. Similarly, various unit/circuit/module/component may be described as performing a task or tasks, for convenience in the description. Such descriptions should be interpreted as including the phrase "configured to" or "adapted to." Reciting a unit/circuit/component that is configured to perform one or more tasks is expressly intended not to invoke 35 U.S.C. § 112, paragraph six interpretation for that unit/circuit/component.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components. Additionally, terms such as first, second, third, are merely used to distinguish elements or components from each other and are not intended to imply an order, sequence, or amount unless expressly stated otherwise.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." The term "about" used herein refers to variations from the reference value or ratio of ± 10% or less (e.g., ± 10%, ± 5%, etc.), inclusive of the endpoints of the range.

In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

In existing optical packages such as co-packaged optics (CPO) packages, the CPO package is typically attached to one or more of a circuit board (e.g., a printed circuit board (PCB) or the like), a connector, a land grid array (LGA), another substrate, or the like by a lid that is separate from the CPO package or a housing of the CPO package. The lid is typically used to cover the CPO package comprising the housing including one or more dies (e.g., one or more electronic dies, one or more photonic dies, a combination of two or more dies, other dies, or the like) and attach the housing to one or more of the circuit board, the PCB, the connector, the LGA, another substrate, or the like. The lid typically makes poor thermal contact with an upper portion of the housing of the CPO package which can cause the one or more dies of the CPO package to overheat.

The subject technology comprises a semiconductor device (e.g., chip, IC, PCB, substrate or other semiconductor device or module) that provides a lid configured to couple or attach an optical package, e.g., CPO package, to one or more of a circuit board, a PCB, a connector, an LGA, another substrate, or the like. In various cases, the lid can be configured to directly cover or directly contact one or more dies of the CPO package without a housing between the lid and the one or more dies of the CPO package. By directly covering or directly contacting the one or more dies, heat can be more effectively dissipated from the CPO package. Further, other features of the lid will be discussed below that provide advantages over existing CPO packages that may use a separate lid.

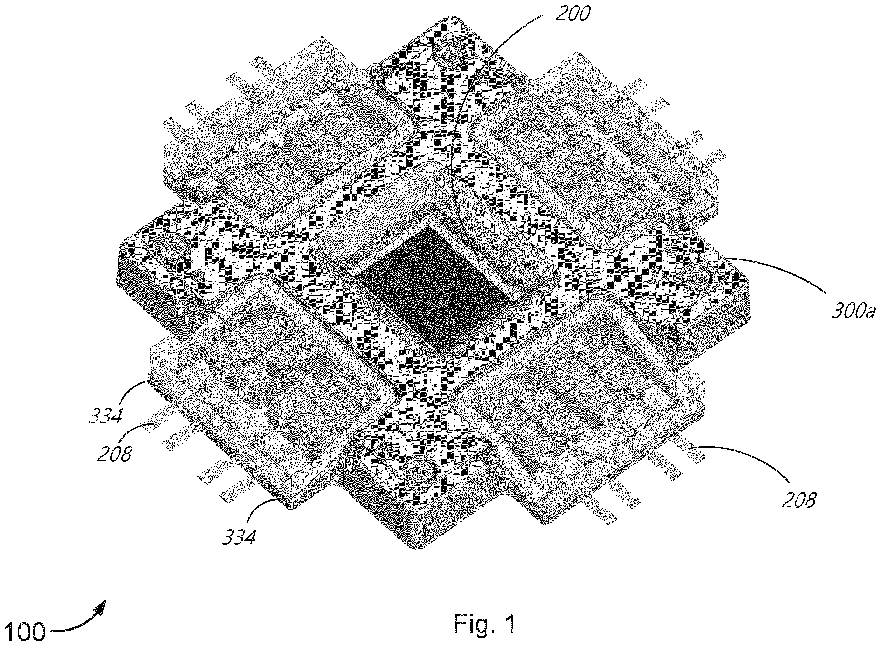

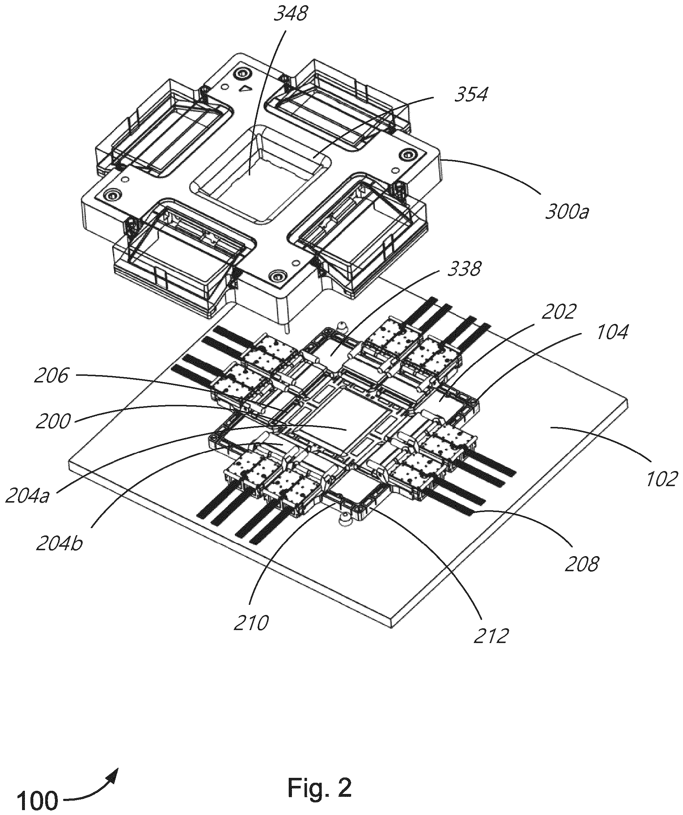

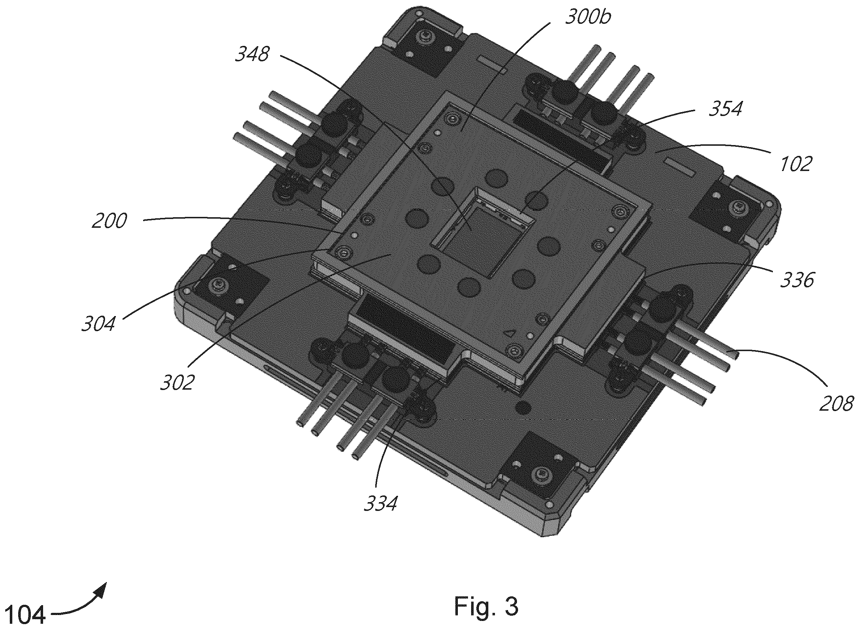

FIG. 1 is a perspective view of a first embodiment of a semiconductor device 100a comprising an optical package such as a CPO package 200. including a first substrate 202 having one or more components, in accordance with various embodiments. FIG. 2 is an exploded view of the semiconductor device 100a comprising the CPO package 200 of FIG. 1. FIG. 3 is a second embodiment of a semiconductor device 100b comprising a CPO package 200 including a first substrate (not shown) having one or more components, in accordance with various embodiments. The semiconductor device 100a and 100b are not intended to be limited to only the components shown in FIGS. 1-3 and could have more or less components than those shown. Additionally, components for semiconductor device 100a could be included in semiconductor device 100b or components for semiconductor device 100b could be included in semiconductor device 100a or the like. When referring to components that semiconductor device 100a and semiconductor device 100b can both include, semiconductor device 100a and semiconductor device 100b are referred to as semiconductor device 100.

In some cases, the semiconductor device 100 can include one or more of a second substrate 102 (e.g., a PCB, a circuit board, or the like) or a connector 104 or other semiconductor components, or the like. In various cases, the CPO package 200 can be coupled to the second substrate 102 or connector 104. In some cases, the CPO package 200 can be attached to the second substrate 102 or connector 104 via a lid 300 (e.g., lid 300a of FIGS. 1 and 2 or lid 300b of FIG. 3).

The second substrate 102 can be a supporting material (e.g., silicon, silicon dioxide, aluminum oxide, gallium, germanium, ceramics, organic structures, laminated organic structures, and/or any other material or combination of materials) upon which or within which elements or components of the semiconductor device 100 or the CPO package 200 are fabricated or attached. The second substrate 102 can include one or more layers (not shown). The one or more layers can include, without limitation, one or more dielectric layers, one or more device or circuit layers, one or more conducting layers, one or more insulating layers, one or more redistribution layers, other layers, and/or the like. The layers may further include one or more routing layers or layers configured to provide component interconnections.

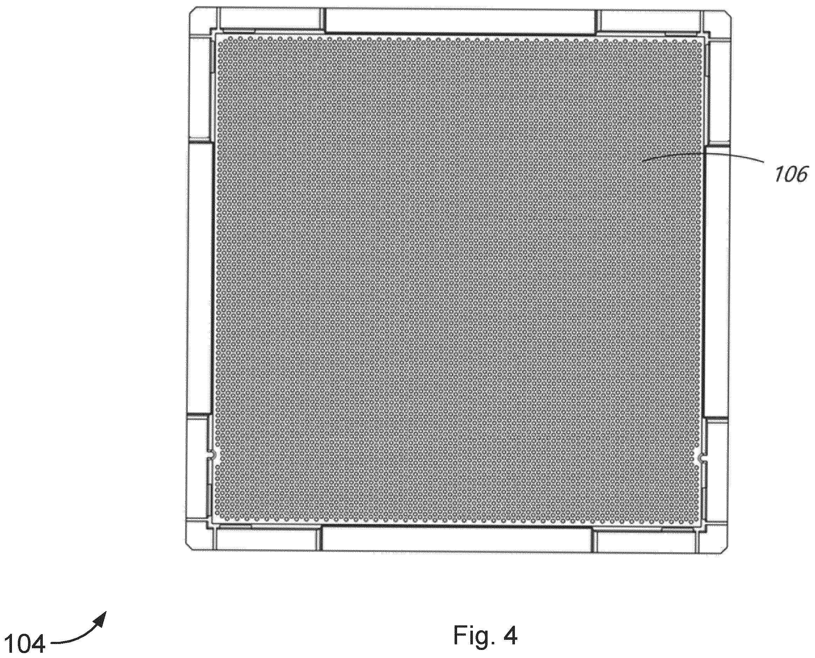

Turning to FIG. 4, the connector 104 (e.g., an LGA, an LGA socket, or the like) of the semiconductor device 100 can be configured to provide electrical interconnects 106 between the second substrate 102 and the CPO package 200. The connector 104 can have one or more electrical interconnects 106 (e.g., springs, pins, bumps, or the like) that provide the electrical connection between the second substrate 102 and the CPO package 200. In various cases, when a force is applied to the connector 104, a first electrical connection can be formed between the connector 104 and the second substrate 102 and a second electrical connection can be formed between the connector 104 and the CPO package 200. In this way, one or more electrical signals, power, or the like can be transmitted through the electrical interconnects 106 of the connector 104 to or from the second substrate from or to the CPO package 200. The one or more electrical interconnects 106 can be arranged in an array or grid pattern or the like. The one or more electrical interconnects 106 can be formed from an electrically conductive material or combination of materials including, but not limited to, one or more of copper, aluminum, titanium, gold, silver, tin, nickel, lead, or a combination of metals/alloys, or may be formed of other electrically conductive material or ,combination of electrically conductive materials.

Turning to the CPO package 200 shown in FIG. 2, the CPO package 200 can be configured to include a first substrate 202 (e.g., a package substrate, or the like). The first substrate 202 can be a supporting material (e.g., silicon, silicon dioxide, aluminum oxide, gallium, germanium, ceramics, organic structures, laminated organic structures, and/or any other material or combination of materials) upon which or within which elements or components of a semiconductor device 100 or the CPO package 200 are fabricated or attached.

The first substrate 202 can include one or more layers (not shown). The one or more layers can include, without limitation, one or more dielectric layers, one or more device or circuit layers, one or more conducting layers, one or more insulating layers, one or more redistribution layers, other layers, and/or the like. The layers may further include one or more routing layers or layers configured to provide component interconnections. In a non-limiting example, connections may be routed, for example, from the second substrate 102 or connector 104 through the first substrate 202 to one or more circuits or dies coupled to the first substrate 202. In some instances, the first substrate 202 is formed from one or more of silicon, silicon germanium, and/or other material or combination of materials.

The first substrate 202 can include or be coupled to one or more circuits or dies. In a non-limiting example, the one or more circuits or dies can include one or more electronic dies, first circuits, electronic circuits, or electronic integrated circuits (EICs) 204, one or more photonic dies, second circuits, photonic circuits, or photonic integrated circuits (PICs) 206, or the like as shown in FIG. 2.

In some cases, the one or more electronic dies 204 can include one or more layers (not shown). The one or more layers can include, without limitation, one or more dielectric layers, one or more device or circuit layers, one or more conducting layers, one or more insulating layers, one or more redistribution layers, other layers, and/or the like. The layers may further include one or more layers configured to provide component interconnections. In a non-limiting example, connections may be routed, for example, through the electronic die 204 via one or more interconnects. In some instances, the electronic die 204 is formed from one or more of silicon, silicon germanium, and/or other material or combination of materials.

In some embodiments, the one or more electronic dies 204 can include an electronic die 204a that can act as a processing unit (e.g., a central processing unit or the like) or a switch application specific integrated circuit (ASIC), or the like. In various cases, the electronic die 204a can be configured to communicate with the one or more photonic dies 206 directly or through one or more controlling circuits or switch circuits 204b. The one or more electronic dies 204 can further include one or more controlling circuits or switch circuits 204b that are configured to communicate with electronic die 204a, photonic dies 206, or other circuits or dies not shown.

The electronic die 204a and the one or more controlling circuits 204b of the electronic die 204 can be configured to control one or more operations of the one or more photonic dies 206, one or more devices in the one or more photonic dies 206, and/or other dies or devices (e.g., a switch die, a digital signal processor die, and/or other dies) disposed within CPO package 200 or semiconductor device 100. The one or more electronic dies 204 can also be configured to transmit electrical signals to or receive electrical signals from the one or more photonic dies 206 and/or other dies or devices disposed within semiconductor device 100. In addition, the one or more electronic dies 204 can include one or more circuits for processing one or more electrical signals that have been converted from one or more optical signals in the one or more photonic dies 206.

In various cases, the one or more electronic dies 204 can be coupled (e.g., communicatively coupled, electrically coupled, attached to, or the like) to one or more photonic dies or photonic integrated circuits (PICS) 206. For example, the CPO package 200 can include eight photonic dies 206. However, the CPO package 200 should not be limited to only eight photonic dies, but could have more or less photonic dies. In some instances, the one or more photonic dies can be formed from one or more of silicon, silicon nitride, indium phosphide, silicon on insulator (SOI), and/or the like. The one or more photonic dies 206 can include one or more layers (not shown). The one or more layers can include, without limitation, one or more dielectric layers, one or more device or circuit layers, one or more conducting layers, one or more insulating layers, one or more redistribution layers, other layers, and/or the like.

The layers may further include one or more layers configured to provide component interconnections. In a non-limiting example, connections may be routed, for example, through the one or more photonic dies 206 via one or more interconnects (not shown). The one or more interconnects of the one or more photonic dies 206 may be configured to provide one or more connections (e.g., electrical connections, optical connections, and/or the like).

The one or more photonic dies 206 can be configured to be coupled (e.g., communicatively coupled, optically coupled, or the like) to one or more optical signal sources 208 such as optical fibers, optical wires, optical cables, photo diodes, light sources, laser dies, or the like. The one or more photonic dies 206 can have one or more circuits configured to receive, transmit, or convert one or more optical signals from the one or more optical signal sources 208. The one or more photonic dies 206 can be configured to receive one or more optical signals from the one or more optical signal sources, transmit the one or more optical signals inside the photonic die 206, transmit the one or more optical signals out of the one or more photonic dies 206, and/or the like. In some cases, the one or more photonic dies 206 can be configured to convert the one or more optical signals received from the one or more optical signal sources 208 to one or more electrical signals and communicate the one or more electrical signals to the one or more electronic dies 204. In some cases, the one or more photonic dies 206 can be configured to receive one or more electrical signals from the one or more electronic dies 204 (e.g., to control the one or more optical sources, to transmit one or more optical signals, to convert one or more optical signals, or the like).

In various cases, the CPO package 200 can further include an optional housing 210 comprising walls 212. The housing 210 can be configured to surround an outer perimeter of the first substrate 202. In various cases, the housing 210 can be part of the connector 104 configured to surround an outer perimeter of the first substrate 202.

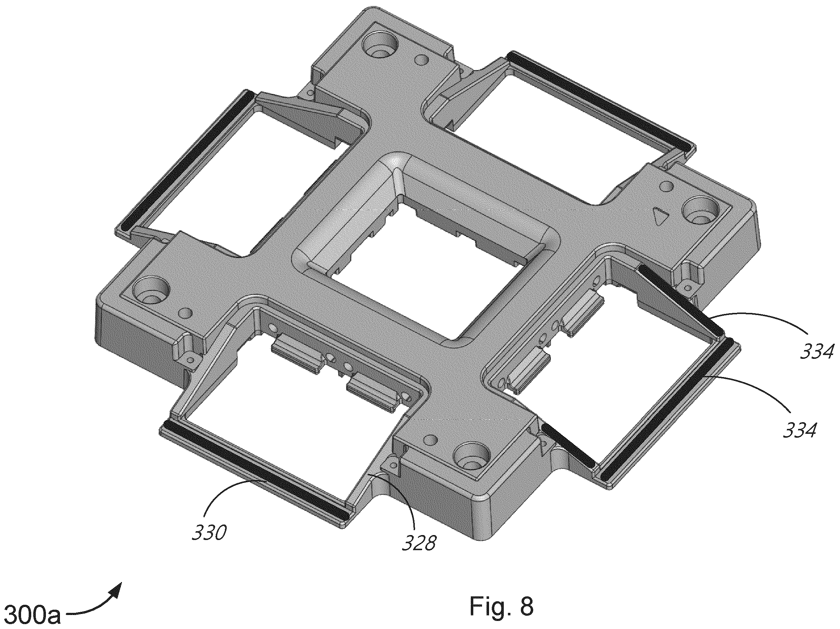

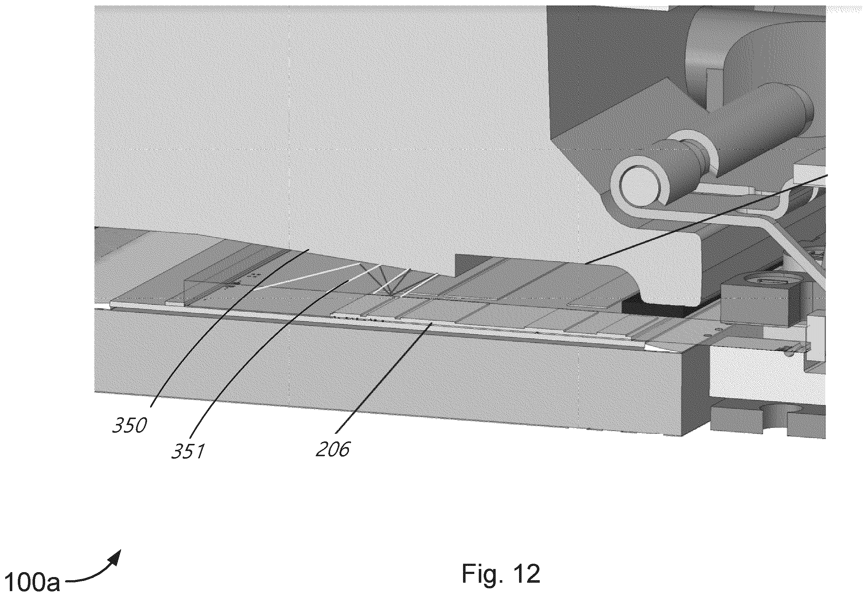

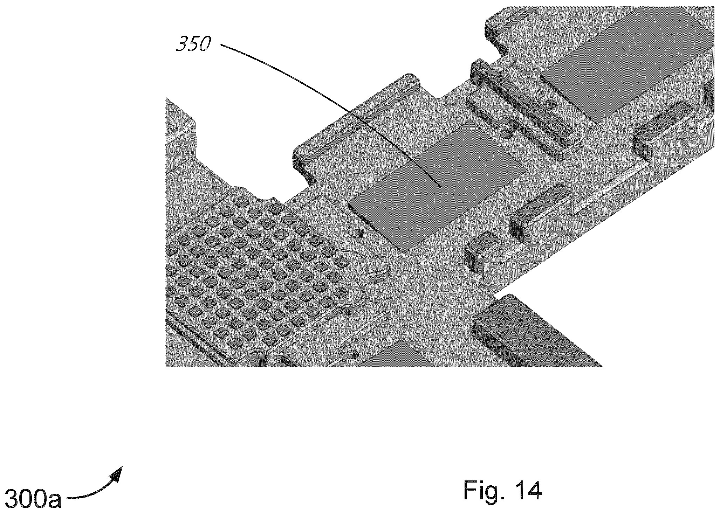

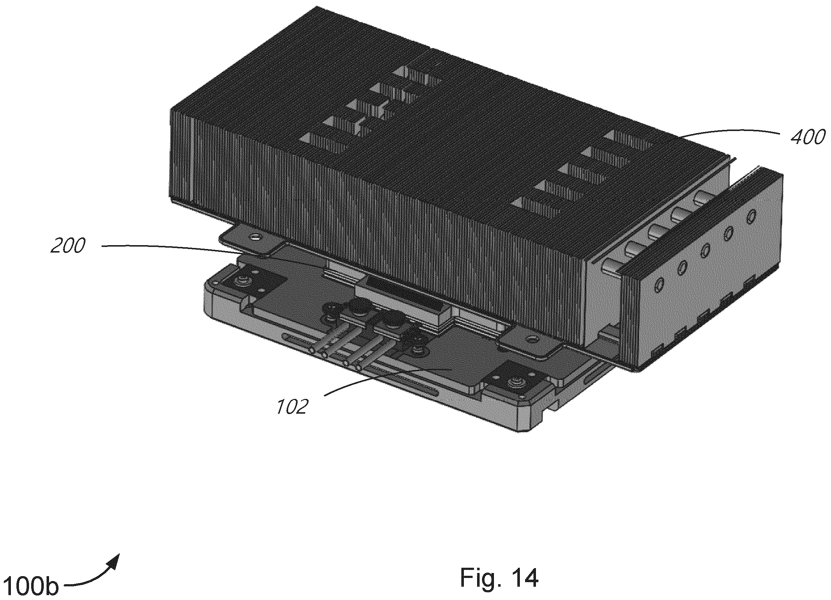

In some embodiments, the CPO package 200 can further include a lid 300 configured to cover or couple to at least a portion of the CPO package (e.g., the first substrate 202, the one or more electronic dies 204, the one or more photonic dies 206, the optical sources 208, the housing 210, or the like). FIGS. 1, 2, 5-and 5-11 show a first embodiment of lid 300a and FIGS. 3 and 14 show a second embodiment of lid 300b. When there are features that are common between lid 300a and 300b the lid will be referred to as lid 300. A person of ordinary skill in the art will understand that the lid 300 can have more or less components than those shown in FIGS. 1-14 and that the lid 300 should not be limited to only the components shown in FIGS. 1-14. Additionally, a person of ordinary skill in the art would understand that the components described with respect to FIGS. 1-14 could be arranged in a variety of configurations or arrangements and that the lid 300 should not be limited to the configuration and arrangements shown. Further, a person of ordinary skill in the art would understand that components of lid 300a could be added to lid 300b, that components of lid 300b could be included in lid 300a, and that the lid 300 is not intended to be limited to only the embodiments shown in the figures.

In various cases, the lid 300 can be configured to couple to one or more of the second substrate 102, the connector 104, the first substrate 202, one or more electronic dies 204, one or more photonic dies 206, the housing 210, or the like. In various cases, the lid 300 can be configured to couple the CPO package 200 to one or more of the second substrate 102, the connector 104, or the like.

In some embodiments, the lid 300 can include a body 302 having an outer surface 304 and an inner surface 308. The lid 300 can further include one or more sidewalls 306. In various instances, the lid 300 or body 302 might be sized and shaped to surround or cover an upper surface of the CPO package 200. In the embodiments shown in the figures, the lid 300 is generally square or rectangular. However, other shapes of the lid 300 are possible. The lid 300 can be formed from a high strength, thermally conductive material or combination of materials including, but not limited to, at least one of copper, zinc, aluminum, or ceramic material or combination of materials or other high strength, thermally conductive material. The lid 300 can be formed using die-casting, forging, stamping, or metal injection molding, or the like

The lid 300 can further include one or more fasteners 310 configured to couple to the outer surface 304 of the body 302. The fasteners 310 can be located at or near one or more corners 312 of the body 302 or around a perimeter 314 of the body 302. The fasteners 310 can include, without limitation, one or more screws, one or more bolts, glue, or other fastener configured to couple the body 302 of the lid 300 to one or more of the second substrate 102, the connector 104, the first substrate 202, one or more electronic dies 204, one or more photonic dies 206, the housing 210, or the like. In FIGS. 1, 2, 3, and 6, four fasteners 310 are shown and configured to couple the lid 300 to one or more of the second substrate 102, the connector 104, the first substrate 202, one or more electronic dies 204, one or more photonic dies 206, the housing 210, or the like. However, there could be more or less fasteners 310 than shown in the figures. In various cases, the one or more fasteners 310 can extend through one or more openings 316 of the body 302 and be configured to attach or directly attach to the second substrate 102 or the connector 104.

In some embodiments, the one or more fasteners 310 can be configured to apply a force to the CPO package 200 or to the first substrate 202 to couple the CPO package 200 or the first substrate 202 to the second substrate 102. In various cases, the force applied by the fasteners 310 can further be configured to resist the force of the interconnects 106 of the connector 104 and form one or more connections between the interconnects 106 of the connector 104 and the second substrate 102 or the first substrate 202. In a non-limiting example, each interconnect of the connector 104 may typically need between 10-30 grams of force to form an electrical connection between the interconnect 106 and the second substrate 102 or first substrate 202. Thus, the force needed to ensure an electrical connection between the interconnects 106 of the connector 104 and the second substrate 102 or first substrate 202 can be high because the lid 300 needs to be configured to resist the force of each interconnect 106 of the connector 104. By positioning the fasteners 310 at one or more corners 312 of the body 302, the force can be distributed over the body 302 of the lid 300 forcing the first substrate 202 or CPO package 200 downward and forming an electrical connection between the one or more interconnects 106 of the connector 104 and the second substrate 102 or the first substrate 202. Additionally, by making the body 302 of the lid 300 about 8 millimeters (mm) to about 12 mm thick, the force of the fasteners 310 can be more evenly distributed throughout the body 302 and the body 302 can be prevented from or experience limited warping.

In various cases, the lid 300a can further include one or more optional openings 318 extending through a top surface 320 of the lid 300a. The one or more optical signal sources 208 can be configured to enter the CPO package 200 through the one or more openings 318 and couple to one or more photonic dies 206.

In various cases, the one or more openings 318 can be formed by a portion of the sidewall 306 of the lid 300a, two opening walls 322a and 322b extending from the sidewall 306, and a bar 324 (e.g., rod, crossbar, crosspiece, member, beam, or the like) extending between walls 322a and 322b. In various cases, the walls 322a and 322b can be sloped or slanted (e.g., about 20 degrees to about 50 degrees or the like). The bar 324 extending across the walls 322a and 322b can be used to further support or provide rigidity to the lid 300a coupled to the first substrate 202, second substrate 102, or the like. As shown for lids 300a, there are four openings 318 extending through the body 302 of the lid 300a. For example, there is one opening on each side of the lid 300a. In various embodiments, there could be more or less openings 318 depending on how many optical sources 208, photonic dies 206, or the like are needed for CPO package 200.

In some embodiments, the one or more openings 318 can be covered by one or more optional covers 326 as shown in FIGS. 1, 2, and 6. The one or more covers 326 can be one or more environmental protectors configured to prevent dust, smoke, moisture, or other debris from entering the one or more openings 318. Environmental protection is important to protect the one or more optical signal sources 208 as just a small amount of dust, smoke, moisture, other debris, or the like can cause the loss of light and the improper functioning of the CPO package 200. In various cases, the one or more covers 326 can be formed from a polycarbonate material or other material, or the like.

In various cases, at least one of a top surface 328 of the walls 322, a top surface 330 of the bar 324, or at least a portion one of a bottom surface 332 of the one or more covers 326 can be lined with a compliant (e.g., deformable, soft, flexible, or the like) material 334 as shown in FIGS. 1, 6, and 8. The material 334 could be foam, fabric, rubber, silicone rubber material, or other soft material, flexible material, compliant material, or deformable material, or combination of materials, or the like. In various cases, a width of the material 334 could be about a same width as a top surface 328 of the walls 322, a top surface 330 of the bar 324, or a bottom surface 332 of the one or more covers 326, or the like. The material 334 can have a tacky or sticky surface that allows the material 334 to be adhered to one or more of the top surface 328 of the walls 322, the top surface 330 of the bar 324, or at least the portion one of the bottom surface 332 of the covers 326.

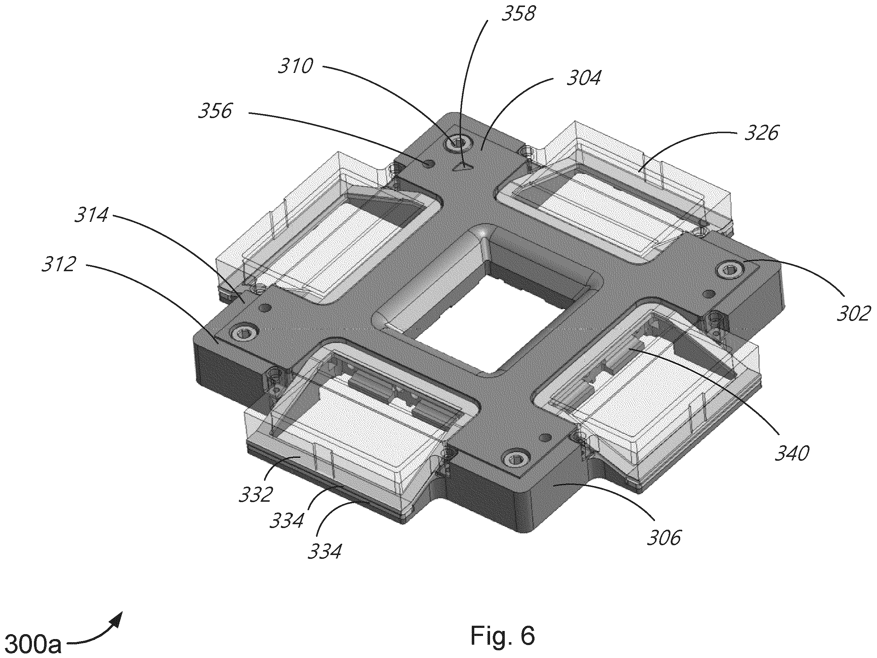

In various cases, as shown in FIGS. 1 and 6, the material 334 could be place on the top surface 330 of a bar 324 and a bottom surface 332 of the cover 326 located over the bar 324 to form a seal (e.g., a full seal, a substantial seal, at least a partial seal, or the like) between the top surface 330 of the bar 324 and the bottom surface 332 of the cover 326 located over the bar 324. The seal can be formed by the material 334 on the top surface 330 of the bar 324 contacting the material 334 of the bottom surface 332 of the cover 326 and deforming around the optical signal sources 208 to enclose, fill, or block any gaps or openings between the top surface 330 of the bar 324, the bottom surface 332 of the cover 326, and the optical signal sources 208 thereby preventing (e.g., fully preventing, substantially preventing, at least partially preventing, or the like) or inhibiting (e.g., fully inhibiting, substantially inhibiting, at least partially inhibiting, or the like) material from passing between the top surface 330 of the bar 324 and the bottom surface 332 of the cover 326. By placing the material 334 on the top surface 330 of the bar 324 and the bottom surface 332 of the cover 326 located over the bar 324, the optical signal sources 208 can be prevented or inhibited from deforming or bending. Further, the material 334 on the top surface 330 of the bar 324 and the bottom surface 332 of the cover 326 can form the seal configured to prevent or inhibit dust, smoke, moisture, or the like from entering the one or more openings 318 and disrupting the light of the one or more optical sources 208.

In some cases, the one or more openings 318 might not be included in the lid 300b as shown in FIG. 3. However, material 334 can still be included between a bottom surface 336 of the lid 300 and a top surface 338 of the first substrate 202 to form a seal (e.g., a full seal, a substantial seal, at least a partial seal, or the like) between the bottom surface 336 of the lid 300 and the top surface 338 of the first substrate 202. The seal can be formed by the material 334 on the bottom surface 336 of the lid 300 contacting the top surface 338 of the first substrate 202 and deforming to enclose, fill, or block any gaps or openings between the bottom surface 336 of the lid 300 and the top surface 338 of the first substrate 202 thereby preventing (e.g., fully preventing, substantially preventing, at least partially preventing, or the like) or inhibiting (e.g., fully inhibiting, substantially inhibiting, at least partially inhibiting, or the like) material from passing between the bottom surface 336 of the lid 300 and the top surface 338 of the first substrate 202. In some cases, the material 334 can be placed on both the bottom surface 336 of the lid 300 and the top surface 338 of the first substrate 202. In some instances, the material 334 can extend about an entire perimeter of the bottom surface 336 of the lid 300b or the top surface 338 of the first substrate 202. Alternatively, the material 334 can be placed at selected locations (e.g., at one or more locations where the optical signal sources 208 enter the CPO package 200, at locations of high stress of the lid 300b, or the like) on the bottom surface of the lid 300b or the top surface of the first substrate 202. Thus, by placing the material 334 on at least one of the bottom surface 336 of the lid 300b and the top surface 338 of the first substrate 202, the optical signal sources 208 can be prevented or inhibited from deforming or bending. Further, the material 334 can prevent or inhibit dust, smoke, moisture, or the like from entering the CPO package 200 and disrupting the light of the one or more optical sources 208.

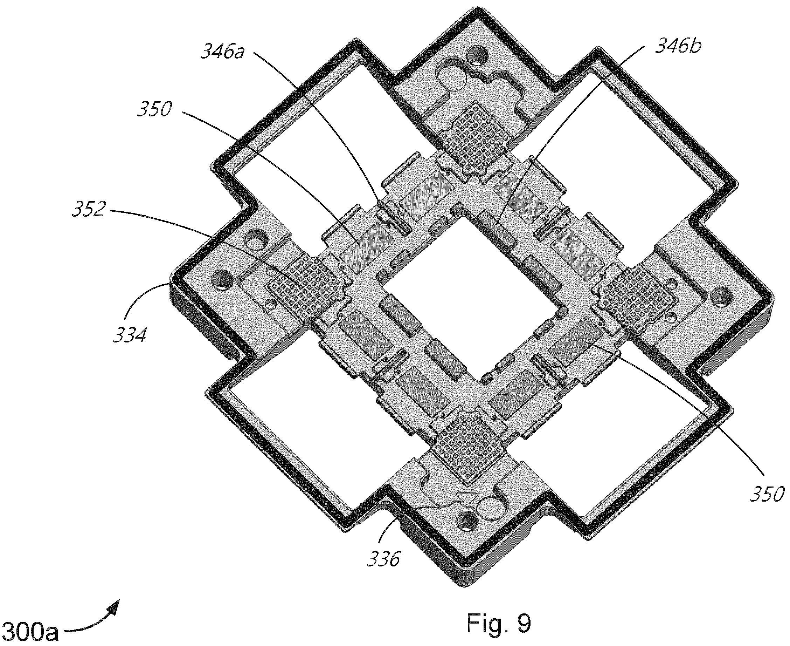

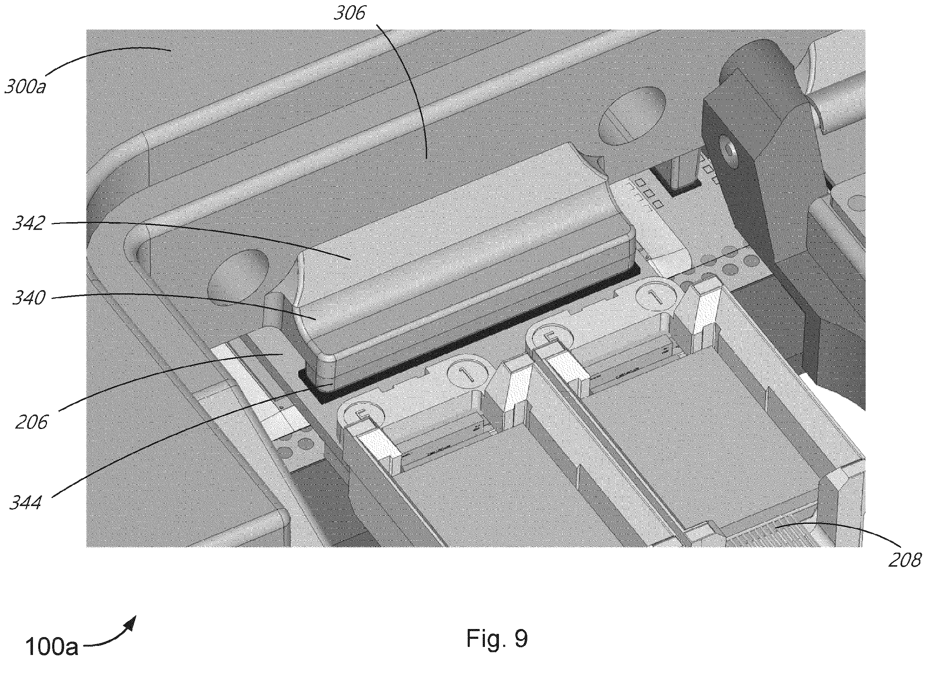

Alternatively, in some instances, when the lid 300a includes the openings 318, as shown in FIG. 9, the material 334 can further be placed between the bottom surface 336 of the lid 300 and the top surface 338 of the first substrate 202. This can be done in addition to or alternative to between each of the covers 326 and a corresponding bar 324. In some instances, the material 334 can extend about an entire perimeter of the bottom surface 336 of the lid or a top surface 338 of the first substrate 202. Alternatively, the material 334 can be placed at selected locations (e.g., at one or more locations where the optical signal sources 208 enter the CPO package 200, at locations of high stress of the lid 300, or the like) on the bottom surface 336 of the lid 300 or the top surface 338 of the first substrate 202. By including the material 334 between the bottom surface 336 of the lid 300 and the top surface 338 of the first substrate 202, a seal (e.g., a full seal, a substantial seal, at least a partial seal, or the like) can be formed between the bottom surface 336 of the lid 300 and the top surface 338 of the first substrate 202. The seal can be formed by the material 334 on the bottom surface 336 of the lid 300 contacting the top surface 338 of the first substrate 202 and deforming to enclose, fill, or block any gaps or openings between the bottom surface 336 of the lid 300 and the top surface 338 of the first substrate 202 thereby preventing (e.g., fully preventing, substantially preventing, at least partially preventing, or the like) or inhibiting (e.g., fully inhibiting, substantially inhibiting, at least partially inhibiting, or the like) material from passing between the bottom surface 336 of the lid 300 and the top surface 338 of the first substrate 202. The seal can be configured to prevent dust, smoke, moisture, debris, or the like from entering the CPO package 200 and protecting one or more of the electronic dies 204, the photonic dies 206, and one or more other components of the CPO package 200.

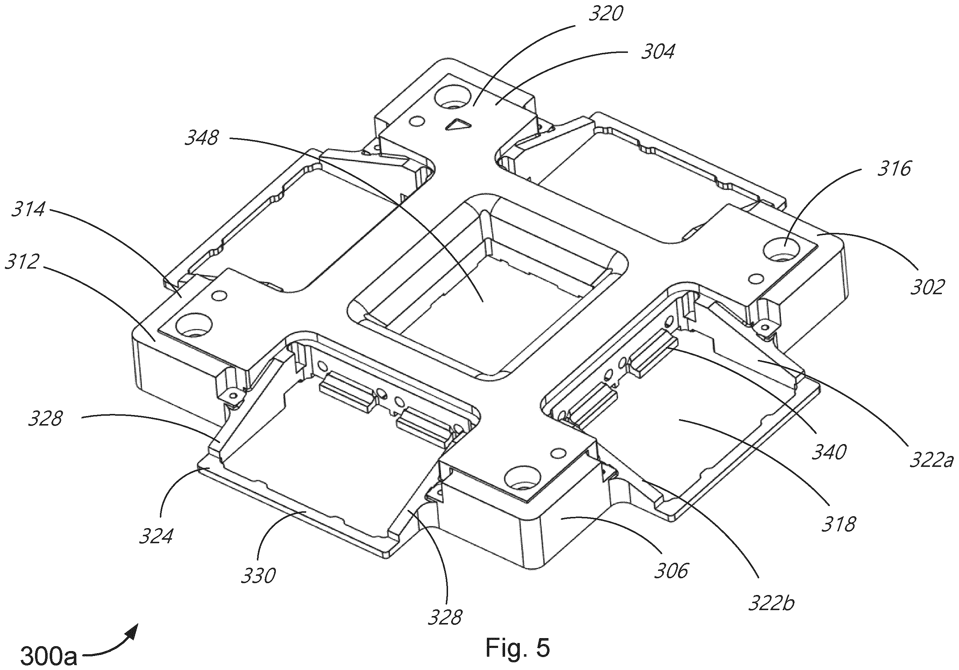

In various instances, as shown in FIGS. 5, 10, and 11, the lid 300 can further include one or more protrusions 340 extending from the one or more sidewalls 306 of the body 302 of the lid 300. In some cases, the one or more protrusions 340 can extend into the one or more openings 318. In various cases, the protrusions 340 can include a first end 342 configured to attach or directly attach to a corresponding sidewall 306 of the body 302 and a second end 344 configured to attach or directly attach to a corresponding photonic die 206 or electronic die 204. In various cases, an optional epoxy, glue, or other attachment structure can be used to couple the second end 344 of the protrusion 340 to the photonic die 206 or electronic die 204.

In some cases, each protrusion 340 can correspond to a photonic die 206 or electronic die 204. In a non-limiting example, if there are eight photonic dies 206, then there can be eight protrusions 340. In various cases, a width of the protrusion can be about a same or substantially a same width as the width of the corresponding photonic die 206 or electronic die 204. By having the width of the of the protrusion 340 be about the same or substantially the same width as the width of the corresponding photonic die 206 or electronic die 204, the photonic die 206 or electronic die 204 can be well supported within the CPO package 200 and prevented or experience limited warping or deformation within the CPO package 200. Alternatively, there could be more or less protrusions 340 than photonic dies 206 or electronic dies 204. In non-limiting examples, two or more protrusions 340 could be coupled to a single photonic die 206 or electronic die 204 or one protrusion 340 can be configured to couple to two or more photonic dies 206 or electronic die 204.

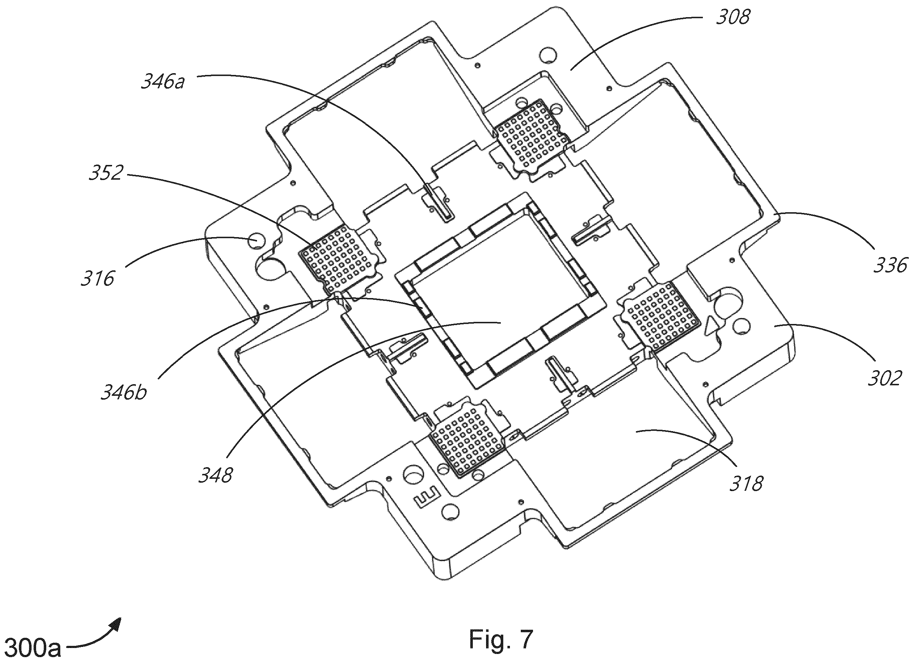

In some embodiments, as shown in FIGS. 7 and 9, the lid 300 can further include one or more support bars 346 (e.g., beams, protrusions, raised elements, or the like) coupled to the bottom surface 332 of the lid 300. The one or more support bars 346 can further support or protect one or more of the one or more electronic dies 204 or the one or more photonic dies 206 or the like. In some instances, a bottom surface of the support bars 346 can contact or directly contact the top surface 338 of the first substrate, an electronic die 204, or a photonic die 206.

In some cases, the one or more support bars 346 can be placed at selected locations on the bottom surface 332 of the lid. In a non-limiting example, one or more support bars 346a can be placed between two photonic dies 206 or two electronic dies 204. Additionally or alternatively, one or more support bars 346b can be placed toward and around an inner aperture 348 of the lid 300. By placing the one or more support bars 346 at selected locations on the bottom surface 332 of the lid 300, one or more of the first substrate 202, the one or more electronic dies 204 or the one or more photonic dies 206 or the like can be protected from deformation caused by forces between the lid 300 and the connector 104.

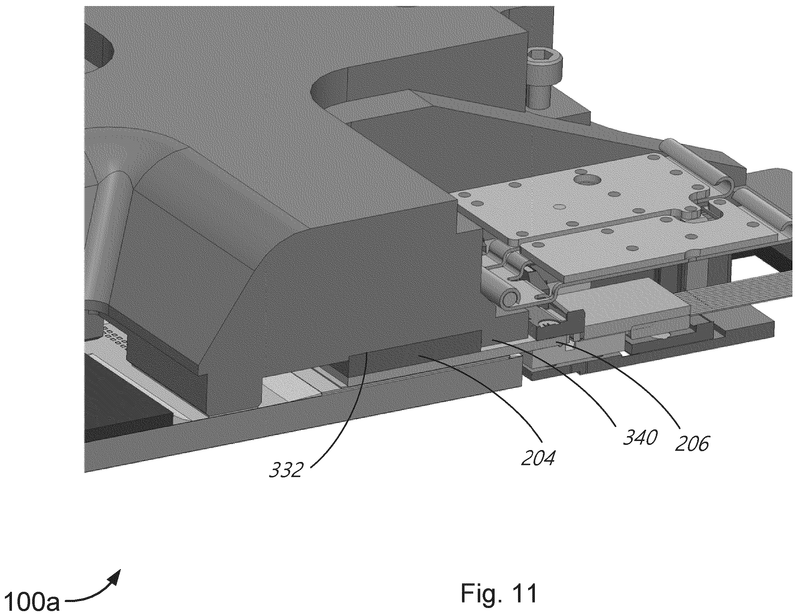

In various cases, as shown in FIG. 11, the bottom surface 332 of the lid 300 can contact (e.g., directly contact or indirectly contact) one or more of the one or more electronic dies 204 or one or more of the photonic dies 206. By directly contacting one or more of the one or more electronic dies 204 or the one or more photonic dies 206, a thermal path can be created between the one or more electronic dies 204 or the one or more photonic dies 206 and the lid 300. In other words, heat is able to move upward from one or more of the one or more electronic dies 204 or the one or more photonic dies 206 through the lid 300 and dissipate away from one or more of the one or more electronic dies 204 or the one or more photonic dies 206. In various cases, by directly contacting the first substrate, the one or more electronic dies 204, or the one or more photonic dies 206, the first substrate, one or more electronic dies 204, or the one or more photonic dies 206 can further be prevented or inhibited from deforming because the force of the lid can be distributed over a larger area of the first substrate, one or more electronic dies 204, or the one or more photonic dies 206.

In various cases, as shown in FIGS. 9, 12, and 13, the bottom surface 332 of the lid 300 contacting one or more of the one or more electronic dies 204 or one or more of the photonic dies 206 can be a slanted surface 350. The one or more slanted surfaces 350 can be located above one or more of the one or more electronic dies 204 or the one or more photonic dies 206. In some cases, the one or more slanted surfaces 350 can directly contact or indirectly contact one or more of the one or more electronic dies 204 or the one or more photonic dies 206. The slanted surfaces 350 can be configured to deflect radiation (indicated by lines 351) away from one or more sensitive areas (e.g., transmitters, receivers, or other sensitive areas or the like) of the one or more electronic dies 204 or the one or more photonic dies 206. In various cases, the slanted surfaces 350 can be sloped between about 1 degree to about 10 degrees.

In some embodiments, as shown in FIGS. 7 and 9, the lid 300 can also include one or more adhesive surfaces 352. The adhesive surface 352 can be configured to cover an entire bottom surface 332 of the lid 300 or be formed at selected locations (e.g., towards one or more corners 312 of the lid 300, at one or more locations where the lid 300 contacts the first substrate 202, or the like) of the bottom surface 332 of the lid. In some cases, the adhesive surfaces 352 can be formed in a grid pattern or as one or more bumps or the like on the bottom surface 332 of the lid. In a non-limiting example, as shown in FIGS. 7 and 9, the adhesive surfaces 352 are formed in a grid pattern towards one or more corners 312 of the bottom surface 332 of the lid 300. The adhesive surfaces 352 can be formed from a glue, epoxy, adhesive material, tacky material, or other material or combination of materials configured to adhere the lid 300 to the first substrate 202. The adhesive surfaces 352 can be configured to adhere the lid 300 to the first substrate 202 and increase the contact surface area between the lid 300 and the first substrate 202. By increasing the contact area between the lid 300 and the first substrate 202 heat can be more effectively dissipated from the first substrate 202.

In various cases, the lid 300 can further include an inner aperture 348 extending through the body 302 of the lid 300. The inner aperture 348 can be located towards a middle or center of the body 302. In various cases, one or more aperture walls 354 of the aperture 348 can be tapered, sloped, slanted, chamfered, or filleted. In various cases, the aperture 348 can be located above an electronic die 204a. In some embodiments, the aperture 348 can be configured to receive a heat sink 400 or other cooling element such as a vapor chamber or the like as shown in FIG. 14. The heat sink 400 or other cooling element can be configured to couple to the aperture 348 and directly contact the electronic die 204a to provide a thermal pathway to dissipate heat from the electronic die 206a. In some cases, the lid 300 can include one or more additional openings 356, shown in FIG. 6, to allow the heat sink 400 or other cooling element to be coupled to the top surface of the lid 300. In some cases, one or more screws, bolts, or other attachment mechanisms can be coupled to openings 356 to couple the heat sink 400 or other cooling element to the lid 300.

In some cases, as shown in FIG. 6, the lid 300 can further include one or more markers 358 (e.g., alignment markers, or the like) located on the top surface 338 of the lid 300. The one or more markers 358 can be used to determine how the lid 300 should be positioned on the first substrate 202. In a non-limiting example, the one or more markers 358 can be aligned with one or more other markers on the first substrate 202 to ensure that the lid 300 is coupled to the first substrate 202 in a selected location or orientation.

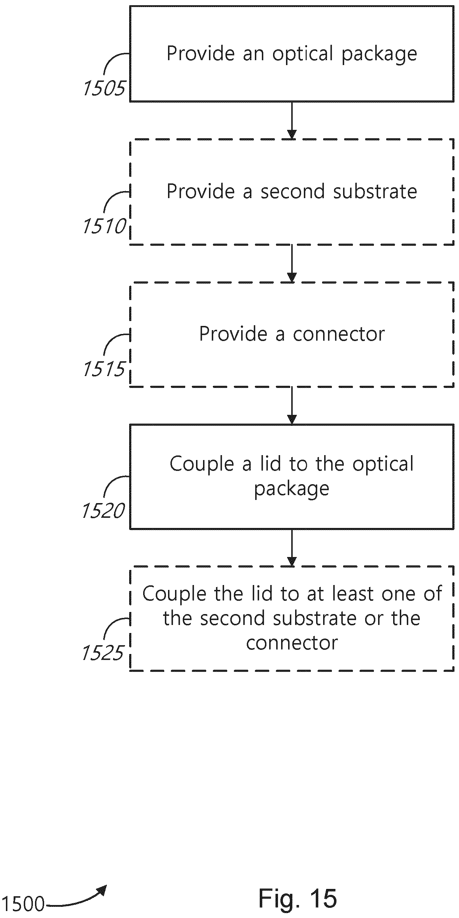

FIG. 15 is a flow diagram of a method of attaching a lid 300 to a semiconductor device 100, in accordance with various embodiments. The method described in FIG. 15 is one way the components of FIGS. 1-14 can be coupled. However, other methods may be used to couple the components of FIGS. 1-14.

The method 1500 may begin, at block 1505, by providing a first optical package (e.g., CPO package 200 or the like). Next, the method can continue at optional block 1510 by providing a second substrate (e.g., second substrate 102, a circuit board, a PCB, another substrate, or the like) and at optional block 1515 by providing a connector (e.g., connector 104, an LGA, or the like).

In various cases, the method 1500, at block 1520, can further include coupling or attaching a lid (e.g., lid 300 or the like) to the optical package. In various cases, at least a portion of the lid can directly cover or directly contact one or more dies (e.g., electronic dies 204, photonic dies 206, other dies, or the like) of the optical package.

Next, the method 1500, at optional block 1525, can include coupling or attaching the lid to at least one of the second substrate or the connector. In various cases, the lid can be used to couple or attach the optical package to at least one of the second substrate or the connector. In some instances, when the lid is used to couple or attach the optical package to the second substrate and the connector, the lid can provide a force that counters the force of the connector and forms a first electrical connection between the second substrate and the connector and a second electrical connection between the connector and the optical package.

The techniques and processes described above with respect to various embodiments may be used to couple or attach the semiconductor devices or components of FIGS. 1-14, and/or components thereof, as described herein.

Moreover, while the procedures of the methods and processes described herein are described in a particular order for ease of description, unless the context dictates otherwise, various procedures may be reordered, added, and/or omitted in accordance with various embodiments. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various embodiments are described with or without some features for ease of description and to illustrate aspects of those embodiments, the various components and/or features described herein with respect to a particular embodiment can be substituted, added and/or subtracted from among other described embodiments, unless the context dictates otherwise. Consequently, although several embodiments are described above, it will be appreciated that the invention is intended to cover all modifications and equivalents within the scope of the following claims.

## Claims

1. An optical package comprising:
a first substrate;
a first circuit coupled to the first substrate and configured to transmit or receive an electrical signal;
a second circuit coupled to the first substrate and configured to transmit or receive an optical signal; and
a lid configured to couple to the first substrate and configured to cover at least one of a portion of the first circuit or a portion of the second circuit.

2. The optical package of claim 1, wherein the lid directly contacts at least one of the portion of the first circuit or the portion of the second circuit.

3. The optical package of claim 1 or 2, wherein the lid is configured to couple the optical package to a second substrate.

4. The optical package of claim 3, wherein the second substrate comprises a printed circuit board, and wherein the lid couples the optical package to the printed circuit board.

5. The optical package of claim 3 or 4, further comprising a connector between the first substrate and the second substrate, wherein the lid comprises a fastener configured to couple the lid to the second substrate, wherein the fastener is configured to provide a force to form a first connection between the first substrate and the connector and a second connection between the connector and the second substrate.

6. The optical package of any preceding claim, wherein the lid comprises an opening configured to receive a source configured to transmit or receive the optical signal, wherein the source is coupled to the second circuit.

7. The optical package of claim 6, wherein the lid further comprises a cover configured to cover the opening.

8. The optical package of claim 7, wherein at least a portion of a bottom surface of the cover comprises a material configured to form a seal surrounding the source as the source enters the opening.

9. The optical package of any preceding claim, wherein the lid comprises an opening configured to receive a source configured to transmit or receive the optical signal, wherein the source is coupled to the second circuit, wherein the opening is formed by a sidewall of the lid, two walls extending from the sidewall, and a bar extending between the two walls extending from the sidewall, and wherein a first material is attached to a top surface of the bar.

10. The optical package of claim 9, wherein the lid further comprises a cover configured to cover the opening, and wherein a second material is attached to at least a portion of a bottom surface of the cover, and wherein the second material is configured to contact the first material and form a seal surrounding the source as the source enters the opening.

11. The optical package of any preceding claim, wherein the lid comprises an opening configured to receive a source configured to transmit or receive the optical signal, wherein the source is coupled to the second circuit, and wherein the lid further comprises a protrusion comprising a first end coupled to and extending from a sidewall of the lid into the opening and a second end coupled to the second circuit.

12. The optical package of claim 11, wherein a width of the protrusion is about a same width as a width of the second circuit.

13. The optical package of any preceding claim, wherein a bottom surface of the lid comprises a bar configured to distribute a force of the lid over the first substrate.

14. An optical system comprising:
a first substrate;
a second substrate;
a connector between the first substrate and the second substrate configured to transmit a first signal between the first substrate and the second substrate;
a circuit coupled to the first substrate and configured to at least one of transmit or receive an optical signal; and
a lid configured to couple the first substrate to the second substrate and form a first connection between the first substrate and the connector and a second connection between the connector and the second substrate to transmit or receive the first signal between the first substrate and the second substrate, and wherein the lid is further configured to directly cover at least a portion of the circuit.

15. A lid for an optical package, the lid comprising:
a body comprising an opening configured to receive a source configured to transmit or receive an optical signal; and
a portion of a bottom surface of the body configured to directly cover at least a portion of a circuit coupled to the source and a first substrate;
wherein the lid is further configured to couple the first substrate to a second substrate and provide a force to form a first connection between the first substrate and a connector and a second connection between the connector and the second substrate to transmit or receive a first signal between the first substrate and the second substrate..
